# EUROPÄISCHE PATENTANMELDUNG

(11) **EP 1 640 471 A2**
(43) Veröffentlichungstag der Anmeldung: **29.03.2006**
(21) Anmeldenummer: 05011770.4
(22) Anmeldetag: 01.06.2005
(51) Int. Cl.: C23C 14/00, C23C 14/50, C23C 14/22, C23C 14/06

(54) **Dampfquelle für Beschichtungsanlage.**

(30) Priorität: 23.09.2004 DE 102004046279
(71) Anmelder: Forschungszentrum Karlsruhe GmbH, 76133 Karlsruhe (DE)
(72) Erfinder: Geerk, Jochen, Dr., 76356 Weingarten (DE); Ratzel, Fritz, 76351 Linkenheim-Hochstetten (DE); Schneider, Rudolf, Dr., 76676 Graben-Neudorf (DE)
(74) Vertreter: Rückert, Friedrich

(57) **Zusammenfassung**

Es wird eine Dampfquelle und ein Beschichtungsteil einer Anlage zur Herstellung dünner Schichten unter Vakuumbedingungen aus mindestens zwei, sich hinsichtlich ihres Dampfdruckes stark unterscheidenden Beschichtungskomponenten vorgestellt. Die Dampfquelle ist aus einem topfförmigen Vorratsbehälter aus gut wärmeleitendem Material für die bei niedrigster Temperatur verdampfende Komponente. Das Beschichtungsteil ist aus einem massiven Block, das Lagergehäuse, aus gut wärmeleitendem Material, vorzugsweise Metall, der einen zentralen vertikalen Durchgangsbereich und eine horizontale, den Durchgangsbereich zentral kreuzende Durchgangsbohrung hat, in der ein drehbar gelagerter Substrathalter sitzt. Der Substrathalter hat an seiner Mantelwand eine ebene Stelle zur Fixierung eines radial nach außen exponierbaren Substrats. Der vertikale Durchgang ist über mindestens einen Kanal durchgängig. Die Dampfquelle und das Lagergehäuse umgeben jeweils eine elektrische Heizung. Über dem Beschichtungsteil steht die Zerstäubungsquelle mit ihrer ausgerichteten Emissionsfläche.

## Beschreibung

Die Erfindung betrifft eine Dampfquelle und ein Beschichtungsteil einer Anlage zur Herstellung dünner Schichten auf einem Substrat unter Vakuumbedingungen aus mindestens zwei, sich hinsichtlich ihres Dampfdruckes unterscheidenden metallischen, halbmetallischen, halbleitenden oder isolierenden Beschichtungskomponenten.

Die Einrichtung zur Herstellung solcher dünnen Schichten besteht aus drei Baugruppen:
der Dampfquelle zur Erzeugung des (Metall-)Dampfes
als der Komponente mit dem hohen/höchsten Dampfdruck der beteiligten Komponenten;
einem Beschichtungsteil,
in dem das Substrat befestigt ist und in den jeweiligen Komponentenstrom exponiert werden kann und
einer Zerstäubungs-/Sputtereinrichtung,
mit der die Beschichtungskomponente mit dem niedrigen/niedrigeren Dampfdruck zerstäubt und als gerichteter, atomarer Teilchenstrahl erzeugt wird.
Mit oder in dieser Anlage werden dünne Schichten in einem kombinatorischen Verfahren über Kathodenzerstäubung und thermisches Verdampfen auf einem Substrat in einem Prozessvakuum hergestellt.

In der DE 103 41 914 wird eine Anlage und ein Verfahren zur Herstellung dünner Schichten, die eine oder mehrere flüchtige Komponenten enthalten, beschrieben. Die Dampfquelle und der Beschichtungsteil bilden zusammen mit der Zerstäubungs-/Sputtereinrichtung zum Emittieren der Komponente mit dem niedrigeren Dampfdruck die grundsätzlichen drei Baugruppen der Anlage für die Herstellung mehrkomponentiger metallischer Dünn/Schichten auf einem Substrat. Die Schichten werden so hergestellt, dass die flüchtigen Komponenten, Komponenten mit hohem Dampfdruck, in dem Ofen durch Elektrowärme verdampft werden. Das Verfahren besteht aus den grundsätzlichen Verfahrensschritten des Verdampfens der niedrig siedenden Komponente mit hohem Dampfdruck und dem Sputtern der hoch- oder höher siedenden Komponente, der Komponente mit niedrigem Dampfdruck. Am Ort des Schichtträgers, des Substrats, soll die höchst mögliche Dampfdichte entstehen. Ziel war die Herstellung von MgB₂₋Schichten. Das Bor-Target steht zentral über dem Verdampfer. Daher kann die Ofentemperatur nicht höher als 530°C gewählt werden. Bei höheren Temperaturen entsteht bei diesem Anlagenaufbau soviel Mg-Dampf, dass das Bor-Target durch den aus der Ofenöffnung ausströmenden Dampf mit einer Mg-Schicht bedeckt wird. Dadurch kommt kein Bor mehr am Substrat an, die Wachstumsrate der Schicht geht gegen Null. Wegen dieser begrenzten Verdampfertemperatur kann die Substrattemperatur nicht höher als 440°C gewählt werden. Die am Substratort erzeugte Mg-Konzentration reicht bei der maximal möglichen Ofentemperatur von 530°C nicht aus, um die MgB₂-Phase oberhalb 440°C zu stabilisieren.

Der Erfindung liegt die Aufgabe zugrunde, bei Beschichten eine Begrenzung der Ofentemperatur auf 530°C und damit der Substrattemperatur auf 440°C zu überwinden, die Bedeckung des Zerstäubungstargets, beispielsweise Bor, mit der Komponente mit hohem Dampfdruck (Mg) unter diesen Betriebsbedingungen zu verhindern, um Schichten insgesamt höherer Qualität bei höherer Substrattemperatur zu erhalten.

Die Erfindung wird durch die Dampfquelle und den Beschichtungsteil der Anlage gemäß den Merkmalen des Anspruchs 1 gelöst. Die Dampfquelle besteht aus einem topfförmigen Vorratsbehälter aus gut wärmeleitendem und wärmebeständigem Material für die bei niedrigster Temperatur verdampfende Komponente mit hohem Dampfdruck. Beispielsweise eignet sich bis zumindest 800°C Edelstahl gut. Das darin zu verdampfende Material wird z. B. in Form eines Granulats in den Behälter geschüttet und über die außen am Boden und am Mantel anliegende elektrische Heizung über die Verdampfungstemperatur erwärmt. Um die Betriebstemperatur zu überwachen und zu stabilisieren, steckt ein Thermoelement in der Wand des Vorratsbehälters, dessen Messwert an eine Steuer- und Regeleinrichtung der Anlage als Istwert geleitet und als Steuer- bzw. Regelgröße einbezogen wird.

Das Beschichtungsteil ist die Baugruppe, in der das zu beschichtende Substrat befestigt ist, die in die vorgesehene Position zur Materialdampf- oder Zerstäubungswolkenexposition des Substrats gebracht werden kann.

Zentrales, unbewegliches Teil ist der massive Block aus wärmebeständigem und gut wärmeleitfähigem Material, wie der Vorratsbehälter, aus Edelstahl beispielsweise. Der Block sitzt auf der Stirn des Vorratsbehälters über eine geringe Berührfläche auf, um den Wärmeübergang vom Vorratsbehälter, der eine deutlich höhere Temperatur hat als der Block, zu unterbinden oder für den Beschichtungsprozess unerheblich zu halten. Das wird über eine schmale ringförmige Kontaktfläche oder bandförmige Kontaktflächen entlang einer Ringlinie oder über eine dazwischen liegende Scheibe aus einer prozessgeeigneten schlecht wärmeleitenden Keramik erreicht. Zur Fixierung kann der Block über Schraubverbindungen mit dem Vorratsbehälter lösbar verbunden sein.

Der Block hat ein zentralen, vertikal verlaufenden Durchgangsbereich und eine horizontale, den Durchgangsbereich zentral kreuzende Durchgangsbohrung. In dieser Durchgangsbohrung sitzt der zylindrische Substrathalter drehbar gelagert. Der Block ist Lagergehäuse für den Substrathalter. Mittig hat der Substrathalter auf der Mantelfläche eine achsparallele, kreissehnenebene Ausfräsung zum Einlegen und Befestigen des zu beschichtenden Substrats. Die Ausfräsung ist so angebracht, dass sie bei entsprechender Drehung des Substrathalters in Richtung der Längsachse des vertikalen Durchgangsbereichs vollständig ausgerichtet werden kann und somit das befestigte Substrat dem Materialdampf aus dem Vorratsbehälter oder dem gerichteten Materialstrom von der Zerstäubungswolke/von der Sputtereinrichtung her hindernisfrei ausgesetzt ist, abwechselnd der einen und der andern Richtung. Deswegen ist die lichte Weite des Durchgangsbereichs mindestens so groß wie die größte Ausdehnung des Substrats, für eine eventuell schräge Exposition des Substrats noch größer. Das Substrat hat auf jeden Fall eine niedrigere Temperatur als der Vorratsbehälter. Der Materialdampf soll sich ja darauf haftend niederschlagen. Damit der Niederschlag aus der Zerstäubungswolke auf die Substratfläche beschränkt bleibt, rotiert der Substrathalter in der horizontalen Bohrung des Blocks unter kleiner Schlitzbildung, so dass von dem Substrathalter allenfalls eine Fläche, deren Projektion der Querschnittsfläche des vertikalen Durchgangsbereichs gleich ist, exponiert ist.

Dem massiven Block, der Lagerung für den Substrathalter, ist außen an der oberen Stirnseite und an der Mantelwand die elektrische Heizung übergestülpt/aufgesetzt. Sie beheizt den Block und damit auch den Substrathalter. Ein in den Block ragender Temperaturfühler misst die Temperatur, über die indirekt auf die im zentralen, bzw. im vertikalen Durchgangsbereich exponierbaren Bereich des Substrathalters geschlossen wird.

Die Heizung hat auf der oberen Stirnseite eine zentrale Öffnung, in die der vertikale Durchgangsbereich völlig mündet. Diese Öffnung weitet sich nach außen hin und steht der darüber aufgestellten Zerstäubungseinrichtung gegenüber, so dass der aus der Zerstäubungs- oder Sputtereinrichtung kommende, atomare Teilchenstrahl ungehindert in den Durchgangsbereich gerichtet und gelangen kann.

Die Heizung hat darüber hinaus eine Positionierungsfunktion, sie hält den Substrathalter axial mit Spiel in Position. Sie hat im Mantelbereich einen Durchgang oder zwei sich gegenüberliegende Durchgänge in der Höhe der Substrathalterachse, mit einer lichten Weite, dass diese von außen für die Antriebswelle ungehindert zugänglich ist. Die von der Anlage wegverlaufende Antriebswelle wird mit ihrem freien Ende an oder in der Achse für das definierte Drehen/Positionieren des Substrathalters lösbar gesteckt.

Bedeutsam für den stabilen Langzeitbetrieb der Anlage ist die nicht betriebsstörende Ablage der Materialdämpfe aus der Dampfquelle oder der gerichtete, atomare Teilchenstrom aus der Zerstäubungswolke innerhalb der Anlage. Das betrifft die ungehinderte Drehung des Substrathalters und den aufrechtzuerhaltenden Temperaturunterschied zwischen Dampfquelle und Beschichtungsteil. Hierzu ragt in den Vorratsbehälter eine am Lagergehäuse abgehängte Scheibe aus dem Material des Vorratsbehälters oder des Lagergehäuses unter Bildung eines schmalen, kreisförmigen Schlitzes mit der inneren Mantelwand des Vorratsbehälters, die einen zentralen Durchgang zu dem vertikalen Durchgang des Blocks des Beschichtungsteils hat.

Die Scheibe/Das Schild soll verhindern, dass sich verdampftes Material im Vorratsbehälter an die obere Stirnseite des Vorratsbehälters haftet und eine gut leitende Wärmebrücke zum Beschichtungsteil herstellt, die die Temperatur des Beschichtungsteils beeinflussen würde. Dieser Durchgang besteht aus mindestens einem Kanal, durch den hindurch der auf dem Substrat abzuscheidende Materialdampf hochströmen soll/muss. Der lichte Querschnitt des oder der Kanäle richtet sich nach dem Dampfdruck und der Dosierung des Materialdampfes. Die Scheibe soll an ihrer zum verschmelzenden Granulat hin exponierten Seite auch nicht beschlagen, allenfalls sehr gering, weil sie der Temperatur des Vorratsbehälters einseitig direkt ausgesetzt ist. Sie berührt das schmelzende Granulat auch nicht. Sie kann an der unteren Stirn des Blocks ansetzen, eventuell wärmeleitungsisoliert oder mit hohem Wärmeleitungswiderstand zum Block, damit der Temperaturunterschied zwischen Dampfquelle und Beschichtungsteil stets aufrechterhalten bleibt.

Der Vorratsbehälter samt Heizung sitzt zur Abschirmung ebenfalls in einem Abschirmbecher. Beide Abschirmbecher berühren sich schmalrandig an ihrem Öffnungsbereich oder kommen sich dort unter schmaler Schlitzbildung nahe. Auch an dieser Stelle soll kein Wärmeübergang stattfinden können, bzw. auf ein tolerables Maß beschränkt bleiben. Das Material der Abschirmbecher ist ein Edelstahlblech, das aufgrund der gewählten Dicke, einige 0,1 mm, die Form unter der Wärmeeinwirkung wahrt. Über die beiden Wärmebecher wird die Wärmeabstrahlung deutlich unterdrückt.

Oben wurde beschrieben, dass der Block, das Lagergehäuse, entweder direkt über eine oder mehrere schmale Kontaktflächen auf dem Vorratsbehälter steht, bzw. an diesen andockt, oder sich eine Keramikringscheibe dazwischen befindet. Konstruktiv kann das über einfache ebene Berührung oder aufwendiger über führende, formschlüssige Berührung wie stufiges Ineinandergreifen auch über eine Ringstruktur geschehen. Dazu kann der Lagergehäuse an seiner Stirn zum Vorratsbehälter hin flanschartig ausgebaut sein oder dort eine Ringnase ausgebildet haben, die wenig in den Vorratsbehälter eingreift aber seitliches Verrücken nicht zulässt. Bekannte mechanische Konstruktionsformen können unter Beachtung der Wärmesituation angewandt werden. Wesentlich ist an diesem Ort die Unterbindung des Wärmeübergangs.

Die Bauform der Dampfquelle und des Beschichtungsteils kann im Querschnitt rund oder rechteckig sein. Von der spanabhebenden Herstellung her ist die runde Bauform naheliegend, ist aber nicht darauf beschränkt.

Im Zusammenbau und für den Betrieb stehen die verpackte Dampfquelle und teilweise das andockende Beschichtungsteil in dem Abschirmrohr aus Keramik, um thermisch gegen die Umgebung zu isolieren.

Um die Wärmeabstrahlung weiter bzw. zusätzlich zu reduzieren, sind der Abschirmbecher des Vorratsbehälters und das von der Heizung umgebene Beschichtungsteil an der nach außen weisenden Stirnseite und Mantelwand jeweils von mindestens einem dünnen Abschirmblech aus Edelstahl oder einem andern wärmebeständigen, gut wärmeleitenden Material umgeben, die im Fall mehrerer solcher dünnen Bleche über Ringscheiben voneinander distanziert sind und sich dadurch allenfalls nur stellenweise berühren, so dass auf jeden Fall die Wärmeleitung durch diese Baumaßnahme behindert wird. Die Öffnung zur Zerstäubungseinrichtung/Sputterquelle bleibt frei, ebenso die Durchgriffe für die Antriebswelle, Temperaturfühler und der Verankerung am Boden des Vorratsbehälters und weiterer, eventuell notwendiger Durchgriffsmöglichkeiten. Die geometrische Baugröße der Anlage und die Zusammensetzung der Dünnschicht auf einem eingelegten Substrat werden beispielhaft unten beschrieben.

Die Anlage zur Beschichtung eines Substrats mit einer mehrkomponentigen Schicht besteht durch diese Bauweise aus einer abgeschlossenen Dampfquelle für die Komponente mit dem höchsten Dampfdruck, einem definiert drehbaren zylinderförmigen Substrathalter und der Zerstäubungsquelle zur Erzeugung des gerichteten, atomaren Teilchenstrahls aus der Komponente mit dem niedrigeren Dampfdruck. Durch diesen Aufbau sind beide Quellen räumlich nahezu hermetisch voneinander getrennt. Durch die Abgeschlossenheit des Innenraums der Dampfquelle und die Aufrechterhaltung der Temperatur über der Verdampfungstemperatur des Materials kann ein so hoher Dampfdruck erzeugt und aufrechterhalten werden, so dass der Niederschlag darin unterdrückt wird. Der Materialdampf entweicht nur durch den oder die Kanäle zum Substrat hin und schlägt sich nicht an Berührstellen zwischen Dampfquelle und Vorratsbehälter nieder. Durch diese Maßnahmen ist eine Langzeitfunktion gewährleistet und damit eine reproduzierbare Dünn-/Schichtherstellung.

Im weiteren wird beispielhaft anhand der Zeichnung die Herstellung einer MgB₂-Dünnschicht auf einem auf dem Substrathalter mit Leitsilber aufgeklebten Saphir-Substrat beschrieben.
Es zeigen:
Fig. 1 die Beschichtungsanlage im Schnitt,
Fig. 2 den Verlauf der Übergangstemperatur zur Supraleitung.

Die ebene Ausnehmung für die Substrateinlage in dem Substrathalter hat eine Rechteckausdehnung von etwa 12 mm x 20 mm.

Das Bor-Sintertarget ist eine Scheibe mit dem Durchmesser von 75 mm und der Dicke von 6 mm. Mit der abgeschlossenen Mg-Dampfquelle und dem drehbaren, indirekt heizbaren, zylinderförmigen Substrathalter 7 wird die Bedeckung des Bor-Targets mit Mg vermieden. Eine separate Erwärmung des Bor-Targets ist nicht praktikabel, da es dabei zerspringt. Durch den konstruktiven Aufbau wird hierdurch eine hermetische Trennung beider Komponentenquellen verhindert.

In dem topfförmigen Vorratsbehälter 1, VB, aus Edelstahl befindet sich festes Mg-Granulat 3. In den den Vorratsbehälter 1 umgebenden Heizungstopf ist der koaxiale Heizleiter 5 mit Hartlot eingelötet. Über ihn wird der Vorratsbehälter 1 erwärmt und das Magnesiumgranulat 3 darin verdampft. Das Thermoelement 14 in der Wand des Vorratsbehälters 1 misst die Verdampfertemperatur Tᵥ, die mit einer über einen Regler betriebenen Spannungsquelle (beide außerhalb der Anlage und nicht eingezeichnet) angefahren und bei Erreichen konstant gehalten wird. Betriebstemperaturen zwischen 300 und 700°C können gefahren werden.

Um die Abstrahlung von Wärme zu reduzieren, ist der Vorratsbehälter 1 mit dem wärmeleitenden inneren Abschirmbecher 12 aus Edelstahl und zusätzlich mit dem nicht wärmeleitenden äußeren Abschirmrohr 13 aus Keramik, hier auch AL₂O₃, umgeben. Der obere Teil der Einrichtung wird auf den VB 1 aufgeschraubt. Der Wärmeübergang zwischen beiden Teilen ist so gering, dass beide Baugruppen thermisch zumindest im Temperaturbereich 300 bis 700°C entkoppelt sind, thermisch nicht prozessbeeinflussend wechselwirken. Dies wird durch die lösbare Schraubverbindung oder einen zusätzlichen schlecht wärmeleitenden Zwischenring aus Keramik erreicht.

Zum oberen Teil gehört die becherförmige Heizung 10 für den Substrathalter 7, welche dem Abschirmbecher 11 mit Öffnung zum Bor-Sputtertarget 2 übergestülpt ist. Das innen sitzende Lagergehäuse 6 für den Substrathalter 7, in dem sich die zwei temperaturbeständigen, ringförmigen, keramischen Lager aus Al₂O₃ zur Aufnahme des zylinderförmigen drehbaren Substrathalters 7 befinden. Das Substrat 4 ist für die Beschichtung auf der achsparallelen, kreissehnenebenen Ausnehmung/Ausfräsung auf dem Zylindermantel mit Leitsilber aufgeklebt. Die Drehung des Substrathalters 7 wird über die in die Achse des Substrathalters 7 mit ihrer Stirn eingesteckte, nicht eingezeichnete Antriebswelle angetrieben. (Die Antriebswelle ist beispielsweise über eine magnetische Schiebe- und Drehdurchführung mit einem regel- und steuerbaren Elektromotor gekoppelt diese Bauteile sind nicht eingezeichnet.)

Die Erwärmung des Substrathalters 7 und des darauf befestigten Substrats 4 erfolgt im wesentlichen über die Wärmestrahlung des Lagergehäuses 6, das durch die Wärmestrahlung der aufgestülpten Heizkappe 10 erhitzt/aufgeheizt wird.

Der Kanal 8 (hier) oder die Kanäle 8 für den Durchtritt des Magnesiumdampfes aus der Dampfquelle im vertikalen Durchgangsbereich des Lagergehäuses 6 ist eine Austrittsbohrung 8 oder sind Austrittsbohrungen 8 mit hier einem Durchmesser von ≈ 1 mm.

Der Spalt zwischen rotierendem Substrathalter 7 und Lagergehäuse 7 beträgt nur ca. 0,1 mm und ist so eng und wegverlängert, dass kein Mg-Dampf durch die Öffnung in den Abschirmbecher 11 entweicht.

Das auf der zentralen, ebenen Ausnehmung des Substrathalters 7 mit Silberlot angeklebte Saphirsubstrat 4 hat eine Betriebstemperatur für die Beschichtung von Tₛ = 500°C und wird wechselweise dem Mg-Dampf, Exposition nach unten, als auch dem durch Zerstäuben (Sputtern) erzeugten Bor-Atomfluss von oben, Exposition nach oben, ausgesetzt, so dass beide Komponenten auf der Substratoberfläche zu der vorgegebenen Verbindung MgB₂ miteinander reagieren können.

Bei den weiter unten angegebenen Substrattemperaturen ist die Mg-Abdampfrate der MgB₂-Schicht noch so gering, dass sich die Schichtoberfläche, während sie nur der Bor-Quelle zugewandt ist, nicht durch Abdampfen von Mg zersetzt. Dies gilt für Rotationsfrequenzen im Bereich von 1 Hz. Da die Mg-Dampfquelle nahezu abgeschlossen ist, wird selbst bei einer Verdampfertemperatur T_{V} von 650°C das B-Target im Betrieb nicht mit einer Mg-Schicht überzogen.

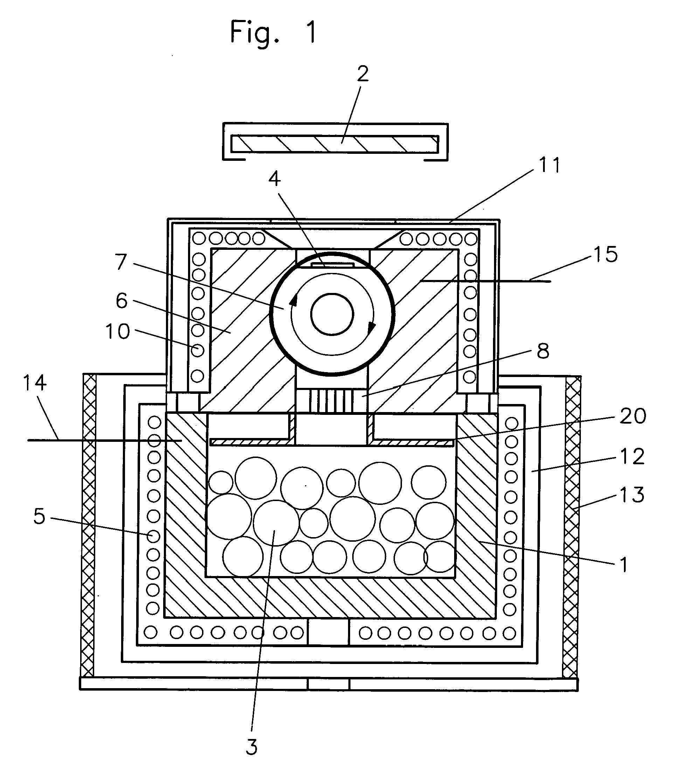

Das Verfahren zur Herstellung einer MgB₂-Schicht mit der oben beschriebenen Einrichtung läuft hier für die MgB₂-Beschichtung folgendermaßen ab:
- die Vakuumkammer, in der sich die in Figur 1 dargestellte Anlage zur Beschichtung befindet, wird mit einer ölfreien Turbomolekularpumpe auf einen Restgasdruck von 2 × 10⁻⁸ mbar evakuiert;
- eine Blende über dem Abschirmbecher 7 mit Öffnung zum Bor-Sputtertarget wird geschlossen;
- die Rotation des Substrathalters 7 wird an einer DC-Spannungsquelle (4 V ≙ 1 Umdrehung pro s) eingeschaltet;
- die Vakuumkammer wird zum Sputtern des Bors mit Argon bis zu einem Druck von 7 × 10⁻³ mbar gefüllt;
- die Substrattemperatur T_{S} wird durch Aufheizen der Heizkappe 10 (in Figur 1: Heizung 10) auf ca. 500°C hochgefahren (T_{S} kann nicht direkt gemessen werden; gemessen wird mit dem Thermoelement 15 die Temperatur des Lagergehäuses 6. Durch Vergleichsmessung bei ruhendem Substrat 4 in höchster Stellung ergibt sich empirisch ein linearer Zusammenhang zwischen T_{S} und der Lagergehäusetemperatur T_{L}; ) T_{S} = 500°C entspricht T_{L} = 520°C;
- das Bor-Target 2 wird mit einer RF-Leistung von 350 W 75 min lang vorgesputtert, bis stationäre Bedingungen erreicht sind;
- der Vorratsbehälter 1 wird auf T_{V} = 650°C aufgeheizt, das Mg-Granulat 3 im VB 1 schmilzt und Mg verdampft; durch die Austrittsbohrungen 8 gelangt Mg-Dampf in der untersten Stellung des Substrathalters 7 zum Substrat 4;
- damit Bor in der obersten Stellung des Substrathalters 7 zum Substrat 4 gelangen kann, wird die Blende geöffnet;
- die typische Depositionsdauer beträgt 60 min. Bei einer Wachstumsrate der Schicht von 3,2 nm /min beträgt die Schichtdicke ca. 200 nm;
- nach erfolgter Deposition wird die Blende geschlossen, die Bor- und Mg-Quelle werden und die Heizkappe 10 wird ausgeschaltet; auf der langsam abkühlenden fertigen MgB₂₋Schicht kondensiert Mg ohne Anwesenheit von B nicht;
- nach Abkühlen der Anlage (Dauer ca. 4 h) wird die Schicht ausgebaut.

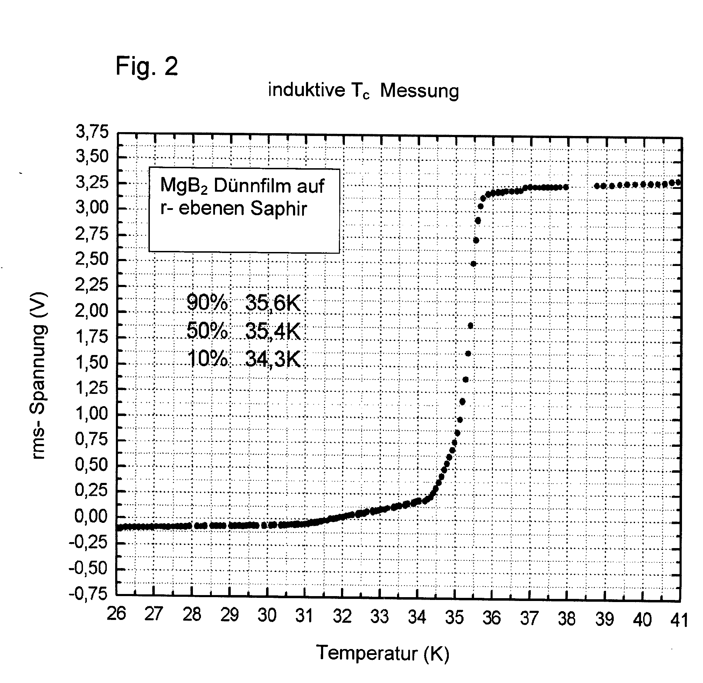

Durch die Anlage und den Beschichtungsprozess gelingt es, die Verdampfertemperatur über 530°C hinaus auf 650°C zu erhöhen, ohne dass das Bor-Target mit Mg bedeckt wird. Durch die damit verbundene Erhöhung des Mg-Dampfdruckes kann die Substrattemperatur T_{S} von 440 auf 500°C erhöht werden. Dies wird dadurch dokumentiert, dass die Übergangstemperatur zur Supraleitung, T_{c}, von 33 K auf 36 K ansteigt (siehe Figur 2).

### Bezugszeichenliste

- 1.: Vorratsbehälter
- 2.: Zerstäubungseinrichtung, Sputtereinrichtung
- 3.: Komponente, Granulat
- 4.: Substrat
- 5.: Heizung
- 6.: Block, Lagergehäuse
- 7.: Substrathalter
- 8.: Kanal, Austrittsbohrung
- 9.: Schild, Deckel
- 10.: Heizung
- 11.: Abschirmbecher, Wärmeschild
- 12.: Abschirmbecher, Wärmeschild
- 13.: Abschirmrohr
- 14.: Thermoelement
- 15.: Thermoelement
- 16.: Einstich
- 17.: Lagerring
- 18.: Gleitlagerring
- 19.: Welle
- 20.: Scheibe

## Patentansprüche

1. Dampfquelle und Beschichtungsteil einer Anlage zur Herstellung dünner Schichten unter Vakuumbedingungen aus mindestens zwei, sich hinsichtlich ihres Dampfdruckes unterscheidenden Beschichtungskomponenten/Elementen, Legierungen oder Verbindungen auf einem Substrat,
wobei:
die Dampfquelle für eine Emissionstemperatur von 300 - 600°C ausgelegt ist und neben einem Beschichtungsteil und einer Zerstäubungs-/Sputtereinrichtung (2) zum Emittieren der Komponente (3) mit dem niedrigen Dampfdruck Bestandteil einer Anlage für die Herstellung/Beschichtung mehrkomponentiger (Dünn-)Schichten auf einem Substrat (4) ist,
die Dampfquelle aus einem topfförmigen Vorratsbehälter (1) aus gut wärmeleitendem Material für die mit hohem Dampfdruck verdampfende, in Form von Granulat (3) eingebrachte metallische, halbmetallische, halbleitende oder isolierende Komponente (3) besteht, an dem außen am Boden und der Mantelwand eine elektrische Heizung (5) topfförmig anliegt,
das Beschichtungsteil aus einem massiven Block (6), das Lagergehäuse, aus gut wärmeleitendem Material, vorzugsweise Edelstahl, besteht, der auf dem stirnseitigen Rand des Vorratsbehälters (1) mit schlechtem Wärmeübergang lösbar andockt, einen zentralen vertikalen Durchgangsbereich und eine horizontale, den Durchgangsbereich zentral kreuzende Durchgangsbohrung hat, in der ein an seinen beiden Endbereichen drehbar gelagerter Substrathalter (7) sitzt, der im mittigen Bereich seiner Mantelfläche eine achsparallele, kreissehnenebene Stelle/Ausnehmung zur Fixierung eines radial nach außen exponierbaren Substrats (4) hat, die in Richtung der Achse des Durchgangsbereichs bei einer Temperatur von 300 - 600°C nach unten oder oben exponiert werden kann,
an dem Durchgang, der zentral zum vertikalen Durchgang hin über mindestens einen Kanal (8) durchgängig ist, zum Vorratsbehälter (1) der Dampfquelle hin ein Schild/Deckel (9) angebracht ist, das/der die Innenwand des Vorratsbehälters (1) nicht berührt und das aufzuheizende bzw. verdampfende Granulat (3) ohne zu berühren abdeckt,
an dem massiven Block (6) außen an seiner oberen Stirn und an seiner Mantelwand eine elektrische Heizung (10) topfartig übergestülpt ist, die eine zentrale, sich nach außen weitende Öffnung in der Stirnseite mit mindestens der lichten Weite des vertikalen Durchgangs am Fuße hat, über der die Emmissionsfläche der Zerstäubungsquelle (2) steht, und zwei sich gegenüberliegende Durchgänge in der Mantelwand als Zugang zu der Achse des Substrathalters (7) hat.

2. Dampfquelle und Beschichtungsteil nach Anspruch 1,
**dadurch gekennzeichnet,**
**dass** ein erster Abschirmbecher (11) als Wärmeschild aus wärmestrahlungreflektierendem Material mit zentraler Öffnung in mindestens der lichten Weite des vertikalen Durchgangs in seinem Boden dem Beschichtungsteil übergestülpt ist und die Dampfquelle samt topfförmiger Heizung (5) in einem zweiten Abschirmbecher (12) als Wärmeschild sitzt/steht.

3. Dampfquelle und Beschichtungsteil nach Anspruch 2,
**dadurch gekennzeichnet,**
**dass** das Lagergehäuse (6) über mindestens einen Ring, wovon mindestens einer aus Keramik ist, auf dem Vorratsbehälter (1) steht.

4. Dampfquelle und Beschichtungsteil nach Anspruch 2,
**dadurch gekennzeichnet,**
**dass** das Lagergehäuse (6) an seiner Stirn zum Vorratsbehälter (1) hin einen geschlossenen oder unterbrochenen, umlaufenden Grat hat, oder nur über eine ringförmige Fläche oder entlang einer einfach geschlossenen Linie liegenden Streifenflächen, die schmäler als die Stirnfläche des Vorratsbehälters (1) ist oder sind, aufsitzt.

5. Dampfquelle und Beschichtungsteil nach den Ansprüchen 2 und 3,
**dadurch gekennzeichnet,**
**dass** eine mit ihrem Endbereich durch die das Lagergehäuse (6) umgebenden Baukomponenten hindurch, in die Achse einführbare Antriebswelle mit ihrer Stirn in eine Mitnehmervorrichtung eingreift, um den Substrathalter (7) drehen oder schrittweise weiterdrehen zu können.

6. Dampfquelle und Beschichtungsteil nach Anspruch 5,
**dadurch gekennzeichnet,**
**dass** die Dampfquelle und das Beschichtungsteil rechteckigen Querschnitt haben.

7. Dampfquelle und Beschichtungsteil nach Anspruch 5,
**dadurch gekennzeichnet,**
**dass** die Dampfquelle und das Beschichtungsteil runden Querschnitt haben.

8. Dampfquelle und Beschichtungsteil nach den Ansprüchen 6 und 7,
**dadurch gekennzeichnet,**
**dass** die betriebsfertige Dampfquelle samt aufsitzendem Beschichtungsteil in einem Abschirmrohr (13) aus schlecht wärmeleitendem Material steht.

9. Dampfquelle und Beschichtungsteil nach Anspruch 8,
**dadurch gekennzeichnet,**
**dass** zwischen der Heizung (5) und dem Abschirmbecher (12) an der Dampfquelle und/oder (10), (11) dem Beschichtungsteil mindestens noch ein blechförmiges Wärmestrahlungsschild befindet, das seine Umgebung allenfalls stellenweise berührt, und, im Falle von mindestens zwei solchen, dieselben sich allenfalls stellenweise berühren.
